# EUROPEAN PATENT APPLICATION

(11) **EP 3 869 548 A1**
(43) Date of publication of application: **25.08.2021**
(21) Application number: 18937233.7
(22) Date of filing: 18.10.2018
(51) Int. Cl.: H01L 23/28, H01L 25/07, H01L 25/18

(54) **SEMICONDUCTOR DEVICE, AND METHOD FOR MANUFACTURING SAME**

(71) Applicant: Nissan Arc, Ltd., Yokosuka-shi, Kanagawa 237-0061 (JP)
(72) Inventor: TANIMOTO, Satoshi, Yokosuka-shi, Kanagawa 237-0061 (JP); YAMASHITA Mari, Yokosuka-shi, Kanagawa 237-0061 (JP)
(74) Representative: Hoefer & Partner Patentanwälte mbB
(86) International application number: PCT/JP2018/038821
(87) International publication number: WO 2020/079798

(57) **Abstract**

A semiconductor device includes a base body (10), a semiconductor chip (40) deposited on a top surface of the base body (10), an encapsulating resin (80) covering the semiconductor chip (40), a ring-shaped plug (70) buried in a part of an upper part of the encapsulating resin (80) and having a top surface exposed to the outside of the encapsulating resin (80), and stand-up terminals (61) each including a vertical part penetrating the ring-shaped plug (70) and extending in a direction perpendicular to the top surface of the base body (10), and having a lower end electrically connected to an electrode of the semiconductor chip (40) inside the encapsulating resin (80) and an upper end exposed to the outside of the encapsulating resin (80), the ring-shaped plug (70) being fixed and bonded to a circumference of a side surface of the vertical parts of the stand-up terminals (61).

## Description

### TECHNICAL FIELD

The present invention relates to a semiconductor device encapsulated with resin and a method of manufacturing the same.

### BACKGROUND ART

To protect against mechanical impact on a semiconductor device and avoid contamination to its surface, resin encapsulation is typically used that covers over and around the surface of the semiconductor device with resin-based insulating material. In the resin-encapsulated semiconductor device, the respective ends of terminals electrically connected to electrodes of a semiconductor chip included in the semiconductor device are exposed to the outside of the encapsulating resin covering the surface of the semiconductor device. For example, terminals extending upward (hereinafter referred to as "stand-up terminals") in a direction substantially perpendicular to a main surface of a base body on which the semiconductor chip is mounted, are placed to penetrate the encapsulating resin (refer to Patent Literature 1).

Patent Literature 1 discloses a technique of transfer molding that injects a material of the encapsulating resin in a cavity of a metallic mold housing the semiconductor device. The straight stick-shaped stand-up terminals are each provided with an encapsulating-resin leakage-prevention valve extending in the horizontal direction at a boundary between an external exposure-side end part exposed to the outside of the encapsulating resin and a device-side interconnection end part covered with the encapsulating resin. The use of the encapsulating-resin leakage-prevention valves prevents the material of the encapsulating resin from leaking to the circumference of the external exposure-side end part when injecting the material of the encapsulating resin to the cavity of the metallic mold.

### CITATION LIST

### PATENT LITERATURE

Patent Literature 1: Japanese Patent No. 5082687

### SUMMARY OF THE INVENTION

### TECHNICAL PROBLEM

The method disclosed in Patent Literature 1 prepares the stand-up terminals provided with the encapsulating-resin leakage-prevention valves formed in the horizontal direction by expansion processing, and fixes the stand-up terminals to the base body by soldering, for example. When the stand-up terminals need to be arranged adjacent to each other, an electrical short circuit is caused due to the contact between the encapsulating-resin leakage-prevention valves of the adjacent stand-up terminals. In addition, when the metallic mold used for the transfer molding is attached to the semiconductor device, the stand-up terminals may be damaged because of breakage or bending of the encapsulating -resin leakage-prevention valves due to the contact with the metallic mold. The conventional method still has a problem of encapsulating the semiconductor device including the stand-up terminals with the resin with achieving a high yield.

In response to this issue, an object of the present invention is to provide a semiconductor device including stand-up terminals capable of avoiding a decrease in yield derived from resin encapsulation, and a method of manufacturing the same.

### SOLUTION TO PROBLEM

An aspect of the present invention is to provide a semiconductor device and a method of manufacturing the semiconductor device in which an encapsulating resin is applied such that a ring-shaped plug precisely aligned with respect to a base body is formed around and bonded on a side surface of a stand-up terminal, and a top surface of the ring-shaped plug is exposed to an upper part of the encapsulating resin.

### ADVANTAGEOUS EFFECTS OF THE INVENTION

The present invention can provide a semiconductor device including stand-up terminals capable of avoiding a decrease in yield derived from resin encapsulation, and a method of manufacturing the same.

### BRIEF DESCRIPTION OF DRAWINGS

[Fig. 1] Fig. 1 is a schematic plan view illustrating a configuration of a semiconductor device according to a first embodiment of the present invention.
[Fig. 2] Fig. 2 is a cross-sectional view taken along II-II direction in Fig. 1.
[Fig. 3] Fig. 3 is a cross-sectional view taken along III-III direction in Fig. 1.
[Fig. 4] Fig. 4 is a schematic plan view for explaining a method of manufacturing the semiconductor device according to the first embodiment of the present invention (Part 1).
[Fig. 5] Fig. 5 is a schematic plan view for explaining the method of manufacturing the semiconductor device according to the first embodiment of the present invention (Part 2).
[Fig. 6] Fig. 6 is a schematic plan view for explaining the method of manufacturing the semiconductor device according to the first embodiment of the present invention (Part 3).
[Fig. 7] Fig. 7 is a schematic plan view for explaining the method of manufacturing the semiconductor device according to the first embodiment of the present invention (Part 4).
[Fig. 8] Fig. 8 is a schematic plan view for explaining the method of manufacturing the semiconductor device according to the first embodiment of the present invention (Part 5).
[Fig. 9] Fig. 9 is a schematic cross-sectional view for explaining a method of forming a ring-shaped plug of the semiconductor device according to the first embodiment of the present invention (Part 1).
[Fig. 10] Fig. 10 is a schematic cross-sectional view for explaining the method of forming the ring-shaped plug of the semiconductor device according to the first embodiment of the present invention (Part 2).
[Fig. 11] Fig. 11 is a schematic cross-sectional view for explaining the method of forming the ring-shaped plug of the semiconductor device according to the first embodiment of the present invention (Part 3).
[Fig. 12] Fig. 12 is a schematic cross-sectional view for explaining the method of forming the ring-shaped plug of the semiconductor device according to the first embodiment of the present invention (Part 4).
[Fig. 13] Fig. 13 is a schematic cross-sectional view for explaining transfer molding applied for the semiconductor device according to the first embodiment of the present invention (Part 1).
[Fig. 14] Fig. 14 is a schematic cross-sectional view for explaining the transfer molding applied for the semiconductor device according to the first embodiment of the present invention (Part 2).
[Fig. 15] Fig. 15 is a schematic cross-sectional view for explaining the transfer molding applied for the semiconductor device according to the first embodiment of the present invention (Part 3).
[Fig. 16] Fig. 16 is a schematic cross-sectional view illustrating a configuration of a semiconductor device of a comparative example.
[Fig. 17] Fig. 17 is a schematic cross-sectional view for explaining transfer molding applied for the semiconductor device of the comparative example.
[Fig. 18] Fig. 18 is a schematic plan view illustrating a configuration of a semiconductor device according to a first modified example of the first embodiment of the present invention.
[Fig. 19] Fig. 19 is a cross-sectional view taken along XIX-XIX direction in Fig. 18.
[Fig. 20] Fig. 20 is a cross-sectional view taken along XX-XX direction in Fig. 18.
[Fig. 21] Fig. 21 is a schematic plan view illustrating a configuration of a semiconductor device according to a second modified example of the first embodiment of the present invention.
[Fig. 22] Fig. 22 is a schematic cross-sectional view for explaining a method of forming a ring-shaped plug of a semiconductor device according to a third modified example of the first embodiment of the present invention (Part 1).
[Fig. 23] Fig. 23 is a schematic cross-sectional view for explaining the method of forming the ring-shaped plug of the semiconductor device according to the third modified example of the first embodiment of the present invention (Part 2).
[Fig. 24] Fig. 24 is a schematic cross-sectional view for explaining the method of forming the ring-shaped plug of the semiconductor device according to the third modified example of the first embodiment of the present invention (Part 3).
[Fig. 25] Fig. 25 is a schematic cross-sectional view for explaining the method of forming the ring-shaped plug of the semiconductor device according to the third modified example of the first embodiment of the present invention (Part 4).
[Fig. 26] Fig. 26 is a schematic plan view illustrating a configuration of a semiconductor device according to a second embodiment of the present invention (Part 1).
[Fig. 27] Fig. 27 is a schematic plan view illustrating the configuration of the semiconductor device according to the second embodiment of the present invention (Part 2).
[Fig. 28] Fig. 28 is a schematic plan view illustrating the configuration of the semiconductor device according to the second embodiment of the present invention (Part 3).
[Fig. 29] Fig. 29 is a cross-sectional view taken along XXIX-XXIX direction in Fig. 27.
[Fig. 30] Fig. 30 is a cross-sectional view taken along XXX-XXX direction in Fig. 27.
[Fig. 31] Fig. 31 is a cross-sectional view taken along XXXI-XXXI direction in Fig. 27.
[Fig. 32] Fig. 32 is a circuit diagram illustrating a configuration of a semiconductor device according to a third embodiment of the present invention.
[Fig. 33] Fig. 33 is a schematic plan view illustrating the configuration of the semiconductor device according to the third embodiment of the present invention (Part 1).
[Fig. 34] Fig. 34 is a schematic plan view illustrating the configuration of the semiconductor device according to the third embodiment of the present invention (Part 2).
[Fig. 35] Fig. 35 is a schematic plan view illustrating the configuration of the semiconductor device according to the third embodiment of the present invention (Part 3).
[Fig. 36] Fig. 36 is a cross-sectional view taken along XXXVI-XXXVI direction in Fig. 34.
[Fig. 37] Fig. 37 is a cross-sectional view taken along XXXVII-XXXVII direction in Fig. 34.
[Fig. 38] Fig. 38 is a cross-sectional view taken along XXXVIII-XXXVIII direction in Fig. 34.

### DESCRIPTION OF EMBODIMENTS

Embodiments and modified examples thereof are described below with reference to the drawings. The relationship between the thicknesses and the planar dimensions and the proportions of the respective layers are exaggerated for illustration purposes. The same elements are basically denoted by the same reference numerals, and overlapping explanations are not made below.

### (First Embodiment)

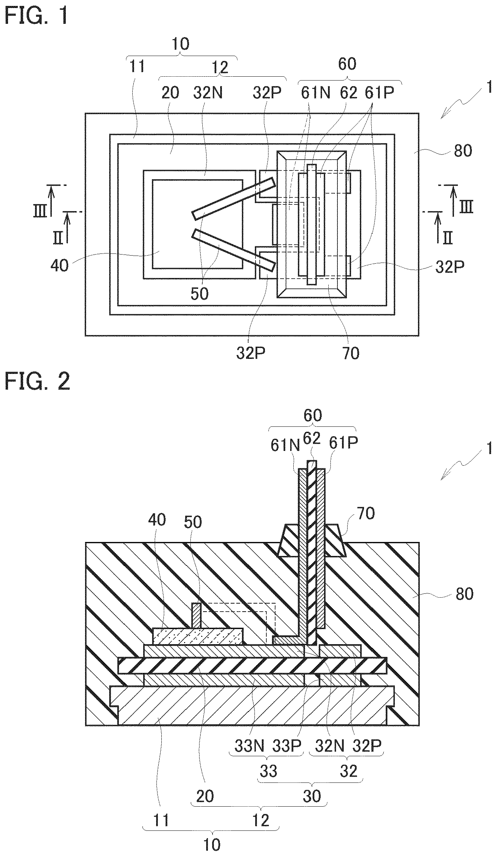

A semiconductor device according to a first embodiment is a semiconductor device encapsulated with resin by transfer molding (referred to below as a "molded semiconductor device"). A structure of the molded semiconductor device 1 according to the first embodiment is described below with reference to Fig. 1 to Fig. 3.

The molded semiconductor device 1 includes a base body 10, a semiconductor chip 40 arranged on the top surface of the base body 10, an encapsulating resin 80 covering the top and side surfaces of the base body 10 and the surface of the semiconductor chip 40, and a ring-shaped plug 70 buried in a part of an upper part of the encapsulating resin 80. The top surface of the ring-shaped plug 70 is exposed to the outside of the encapsulating resin 80. Fig. 1 is a plan view illustrating the encapsulating resin 80 and the ring-shaped plug 70 in a transparent state.

The base body 10 includes a circuit substrate 12 in which a plurality of conductor pieces 30 are arranged on a main surface of an insulating substrate 20. The molded semiconductor device 1 further includes a first stand-up terminal 61N and a second stand-up terminal 61P with the respective upper ends exposed to the outside of the encapsulating resin 80. The stand-up terminals included in the molded semiconductor device 1 are collectively referred to below as "stand-up terminals 61". The stand-up terminals 61 each includes a vertical part penetrating the ring-shaped plug 70 and extending in a direction perpendicular to the top surface of the base body 10. The respective lower ends of the stand-up terminals 61 are electrically connected to terminals (not illustrated) of the semiconductor chip 40 inside the encapsulating resin 80, as described below. The ring-shaped plug 70 is formed around and bonded on a side surface of the vertical parts of the respective stand-up terminals 61.

The molded semiconductor device 1 is a power semiconductor device, for example, in which the semiconductor chip 40 is provided with a semiconductor element such as a diode element or a transistor element. The present embodiment is illustrated below with the case in which the semiconductor chip 40 is provided with the semiconductor element through which a main current flows between a front-surface electrode (not illustrated) arranged on the front surface of the semiconductor chip 40 and a rear-surface electrode arranged on the rear surface.

As illustrated in Fig. 1 to Fig. 3, the stand-up terminals 61 each have a plate-like shape. The stand-up terminals 61 have the lower ends provided with an L-shaped part bent in parallel to the main surface of the base body 10. The short part of the L-shaped part of the respective stand-up terminals 61 (referred to below as a "leg part") is arranged on the top surface of the circuit substrate 12. The vertical part of the respective stand-up terminals 61 that is the longitudinal part of the L-shaped part is partly exposed to the outside of the encapsulating resin 80. The part of the respective stand-up terminals 61 exposed to the outside of the encapsulating resin 80 is referred to below as an "outer lead", and the part covered with the encapsulating resin 80 is referred to below as an "inner lead".

The base body 10 has a configuration in which the circuit substrate 12 is deposited on a top surface of a base plate 11. At least the top and side surfaces of the base plate 11 are covered with the encapsulating resin 80. The plural delineated conductor pieces 30 having a thin-film shape are arranged on the top surface of the insulating substrate 20, and a circuit pattern is provided on the main surface of the circuit substrate 12. The stand-up terminals 61 and the electrodes of the semiconductor chip 40 are electrically connected to each other via the conductor pieces 30.

In particular, the semiconductor chip 40 is deposited on a top surface of a first terminal conductor piece 32N so that the first terminal semiconductor piece 32N arranged on the top surface of the circuit substrate 12 is electrically connected to the rear-surface electrode of the semiconductor chip 40. The leg part of the first stand-up terminal 61N is connected to the top surface of the first terminal conductor piece 32N separately from the semiconductor chip 40. The rear-surface electrode of the semiconductor chip 40 is thus electrically connected to the first stand-up terminal 61N.

The front-surface electrode of the semiconductor chip 40 is connected with the respective one ends of interconnects 50. The other ends of the interconnects 50 are connected to a second terminal conductor piece 32P arranged on the top surface of the circuit substrate 12 separately from the first terminal conductor piece 32N. The leg part of the second stand-up terminal 61P is connected to the second terminal conductor piece 32P. The front-surface electrode of the semiconductor chip 40 is thus electrically connected to the second stand-up terminal 61P.

The respective vertical parts of the first stand-up terminal 61N and the second stand-up terminal 61P are arranged on different main surfaces of an insulating plate 62. The molded semiconductor device 1 includes a constituent component in which the vertical parts of the stand-up terminals 61 and the insulating plate 62 are combined together (referred to below as a "terminal assembly 60"). The upper end of the terminal assembly 60 is exposed to the outside of the encapsulating resin 80, while the ring-shaped plug 70 is formed around and bonded on a side surface of the terminal assembly 60.

The molded semiconductor device 1 thus has a configuration in which the terminal assembly 60 penetrates the ring-shaped plug 70 partly buried in the upper part of the encapsulating resin 80. The outer lead of the respective stand-up terminals 61 are exposed to the outside of the encapsulating resin 80. The ring-shaped plug 70 is provided to be fixed to the side surface of the terminal assembly 60 at a predetermined height. As described in detail below, the ring-shaped plug 70 is positioned (aligned) with respect to the base body 10 with high precision.

As described above, the molded semiconductor device 1 is covered with the encapsulating resin 80 excluding the bottom of the base plate 11 and a part of the terminal assembly 60 above the ring-shaped plug 70. The respective elements of the molded semiconductor device 1 are described in more detail below.

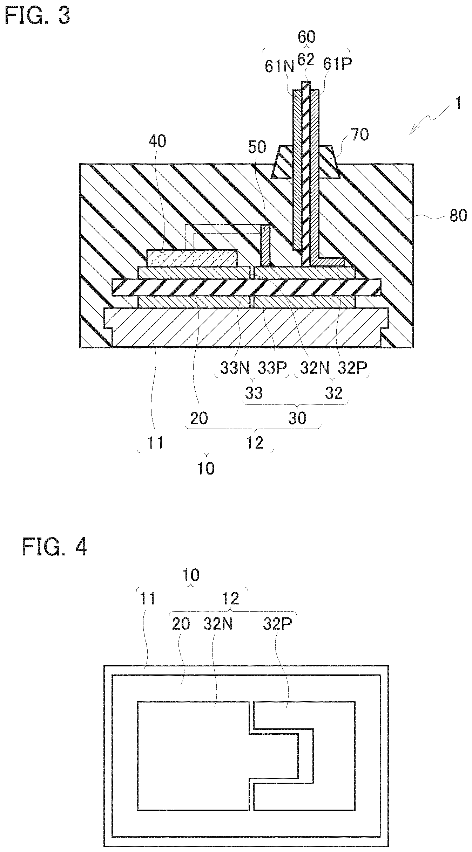

The base plate 11 is a solid plate, a combined plate (a laminated plate), or a composite plate made of copper, aluminum, molybdenum, tungsten, nickel, chromium, iron, titanium, or an alloy based on these metals as a matrix. The base plate 11 includes the material having higher mechanical strength than that used for the circuit substrate 12. To increase the adhesiveness of the encapsulating resin 80 with respect to the base plate 11, the side surfaces of the base plate 11 may be processed into an inversely-stepped shape having shorter circumferential sides as closer to the bottom surface, as illustrated in Fig. 2 and Fig. 3. The base plate 11 may serve as a heat sink for releasing heat generated in the semiconductor chip 40. The base plate 11 in this case is preferably designed to include a material and have a structure so as to lead a coefficient of thermal expansion in the main-surface direction to approximate to that of the circuit substrate 12 as much as possible to improve the heat conductivity of the base plate 11 in the thickness direction.

The circuit substrate 12 has a configuration in which the plural conductor pieces 30 are arranged on the top surface of the insulating substrate 20 and are electrically isolated from each other. The molded semiconductor device 1 illustrated in Fig. 2 includes the first terminal conductor piece 32N and the second terminal conductor piece 32P. The bottom surface of the insulating substrate 20 may also be provided with the semiconductor pieces. The semiconductor pieces 30 deposited on the top surface of the insulating substrate 20 in this case are preferably arranged to include the same material and have the same thickness as the conductor pieces deposited on the bottom surface of the insulating substrate 20 so as to have a plane of symmetry about the insulating substrate 20. This configuration can substantially equalize the thermal expansion between the top surface and the bottom surface of the insulating substrate 20, so as to avoid a warp of the circuit substrate 12 during a heating assembly process.

The conductor pieces 30 arranged on the top surface of the insulating substrate 20 such as the first terminal conductor piece 32N and the second terminal conductor piece 32P are referred to below as "upper-surface conductor pieces 32", and the conductor pieces 30 arranged on the bottom surface of the insulating substrate 20 are referred to below as "lower-surface conductor pieces 33". The molded semiconductor device 1 is provided with the lower-surface conductor piece 33N to be opposed to the first terminal conductor piece (upper-surface conductor pieces) 32N, and is provided with the lower-surface conductor piece 33P to be opposed to the second terminal conductor piece (upper-surface conductor pieces) 32P.

A thin ceramic plate made of material such as silicon nitride, alumina, and aluminum nitride is suitably used for the insulating substrate 20. Any other plate made of other inorganic material and organic material that has the insulating properties, heat conductivity, and mechanical strength equivalent to the above material may be used for the insulating substrate 20 instead.

The conductor pieces 30 each can be a copper plate or an aluminum plate, or a composite plate using these plates as base members and combined together. The conductor plates 30 are formed such that these conductor plates are attached to both surfaces of the insulating substrate 20 by direct bonding or active metal brazing, and then delineated by photolithography. The surface of the respective upper-surface conductor pieces 32 is covered and plated by Ni/Al plating or Ni/Ag plating as appropriate so as to facilitate the bonding to the semiconductor chip 40 and improve the reliability of the product.

The present embodiment is illustrated with the molded semiconductor device 1 in which the semiconductor chip 40 includes the semiconductor element having two terminals. The molded semiconductor device 1 may include any type of the semiconductor element provided on the semiconductor chip 40. The semiconductor element may be a p-n junction diode or a Schottky junction diode when having two terminals. The semiconductor element to be used may be optionally selected depending on the use from a metal-oxide-semiconductor field-effect transistor (MOSFET), an insulated gate bipolar transistor (IGBT), a bipolar junction transistor (BJT), a junctiongate field-effect transistor (JFET), and a high electron mobility transistor (HEMT) when having three terminals. The rear surface of the semiconductor chip 40 is provided with a Ti/Ni/Au multi-layer film or a Ti/Ni/Ag multi-layer film, for example, so as to facilitate the bonding to the first terminal conductor piece 32N.

The interconnects 50 electrically connect the front-surface electrode of the semiconductor chip 40 and the second terminal conductor piece 32P. This connection can be easily made by a wire bonding method using a thick wire made of aluminum, copper, or gold as the respective interconnects 50. Alternatively, the interconnectors 50 may be formed by a combination of a clip lead obtained from a copper plate subjected to cutting and bending processing and soldering (or conductive paste bonding).

The terminal assembly 60 has a structure in which the first-stand-up terminal 61N and the second stand-up terminal 61P are opposed to each other while interposing the thin insulating plate 62 therebetween. The terminal assembly 60 is arranged over the boundary between the first terminal conductor piece 32N and the second terminal conductor piece 32P. The foot of the inner lead of the first stand-up terminal 61N is electrically and mechanically connected to the first terminal conductor piece 32N. The foot of the inner lead of the second stand-up terminal 61P is electrically and mechanically connected to the second terminal conductor piece 32P.

The ring-shaped plug 70 is made of a solid insulating material fixed and bonded along the circumference of the side surfaces of the terminal assembly 60 at a predetermined position. The ring-shaped plug 70 covers the predetermined position of the terminal assembly 60 including the boundary between the inner lead and the outer lead of the stand-up terminals 61. The ring-shaped plug 70 is not a component of the terminal assembly 60 but is an independent member. The ring-shaped plug 70 is not a component obtained such that a part of the stand-up terminals 61 is deformed by expansion processing, for example. The ring-shaped plug 70 can be formed into a shape that extends in the horizontal direction, and can be used together with the stand-up terminals 61 having a plate shape that is difficult to partly extend in the horizontal direction by expansion processing.

In addition to the characteristics described above, the ring-shaped plug 70 needs to have heat resistance and mechanical strength sufficient to withstand the molding temperature during the transfer molding and the clamping pressure of the metallic mold. A material used for the ring-shaped plug 70 may be selected from, but not limited to, a silicone-based adhesive, an epoxy-based adhesive, or a polyimide-based adhesive. An inorganic substance that satisfies the above conditions may be used for the ring-shaped plug 70.

As illustrated in Fig. 2 and Fig. 3, the lower part of the ring-shaped plug70 is buried in the encapsulating resin 80, and the upper part is exposed to the encapsulating resin 80. For example, as illustrated in the drawings, the ring-shaped plug 70 has a truncated cone shape having a trapezoidal shape in cross section in which the upper base is shorter than the lower base.

The ring-shaped plug 70 is provided so as to reliably seal an open part of the space (the cavity) of the metallic mold corresponding to a region holding the outer lead of the terminal assembly 60 when the transfer molding is executed by use of the metallic mold for the molded semiconductor device 1 before being encapsulated with the resin (referred to below as a "precursor structure body IP"). The ring-shaped plug 70 is formed around and bonded on a side surface of the terminal assembly 60 to be located at a boundary between a non-molded region of the cavity holding a part of the molded semiconductor device 1 exposed to the outside of the encapsulating resin 80 and a molded region of the cavity into which the encapsulating resin is injected. The provision of the ring-shaped plug 70 prevents the encapsulating resin 80 from being injected to the non-molded region.

The ring-shaped plug 70 is formed around and bonded on the side surface of the terminal assembly 60 during the process between a step of attaching the terminal assembly 60 to the circuit substrate 12 and a step of molding the precursor structure body 1P with the encapsulating resin 80. The ring-shaped plug 70 is provided at a position precisely defined with a high alignment accuracy by use of a dedicated jig on the basis of the base body 10 for the alignment.

The encapsulating resin 80 used may be a general-purpose polymer typically used in transfer molding for power semiconductor devices. For example, thermosetting epoxy resin or a composite material of thermosetting imide resin and inorganic filler may be used for the encapsulating resin 80.

The semiconductor device according to the first embodiment is suitably used in the case in which the diode element is formed on the semiconductor chip 40. For example, when the front-surface electrode of the semiconductor chip 40 serves as an anode, and the rear-surface electrode serves a cathode, a main current of the diode element flows in via the second stand-up terminal 61P and flows out via the first stand-up terminal 61N. The use of the stand-up terminals 61 can decrease the installation area of the molded semiconductor device 1 as compared with the case in which the leads are arranged on the side surfaces of the molded semiconductor device 1. The use of the stand-up terminals 61 can also allow other components to be arranged adjacent to the periphery of the molded semiconductor device 1 in a plan view. The use of the stand-up terminals 61 can further allow a component connected to the molded semiconductor device 1 to be arranged over the molded semiconductor device 1.

A method of manufacturing the semiconductor device according to the first embodiment is described below with reference to the drawings. The method of manufacturing the semiconductor device described below is an example, and the semiconductor device may be fabricated by various kinds of methods including modified examples of the present embodiment. This method can also be applied to a method of manufacturing a semiconductor device according to other embodiments described below.

First, the processed members necessary for manufacturing the molded semiconductor device 1 are prepared. The processed members such as the base plate 11, the circuit substrate 12, and the terminal assembly 60 are purchased or manufactured by known processing means (including machining, cutting, bending, and bonding). For example, the circuit substrate 12 is formed such that metallic plates provided on both sides of the insulating substrate 20 made of ceramics, for example, are delineated by etching. The terminal assembly 60 is formed such that the plate-shaped first stand-up terminal 61N and second stand-up terminal 61P are bonded to both surfaces of the insulating plate 60 made of ceramics, for example.

As illustrated in Fig. 4, the circuit substrate 12 is then bonded to a predetermined position on the top surface of the base plate 11. This bonding is made such that the lower-surface conductor pieces 33 are fixed and bonded to the top surface of the base plate 11 by a method such as silver brazing, soldering, or thermal diffusion bonding via an aluminum foil. The surface of the upper-surface conductor pieces 32 may further be covered and plated by Ni/Au plating or Ni/Ag plating as necessary.

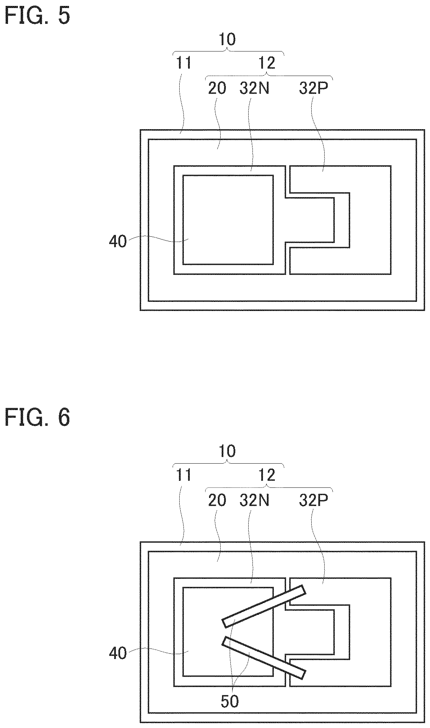

Next, as illustrated in Fig. 5, the rear-surface electrode of the semiconductor chip 40 is bonded at a predetermined position on the top surface of the first terminal conductor piece 32N by soldering, metal particle sintering, or conductive paste.

Next, as illustrated in Fig. 6, the front-surface electrode of the semiconductor chip 40 and the second terminal conductor piece 32P are electrically connected to each other via the interconnects 50. For example, a thick wire or ribbon made of aluminum, copper, or gold is used for the interconnects 50 to connect between the front-surface electrode of the semiconductor chip 40 and the second terminal conductor piece 32P by a known wire bonding method (such as ball bonding or wedge bonding). Alternatively, the front-surface electrode of the semiconductor chip 40 and the second terminal conductor piece 32P may be electrically connected to each other via clip leads used as the interconnects 50 by soldering, metal particle sintering, or conductive paste bonding.

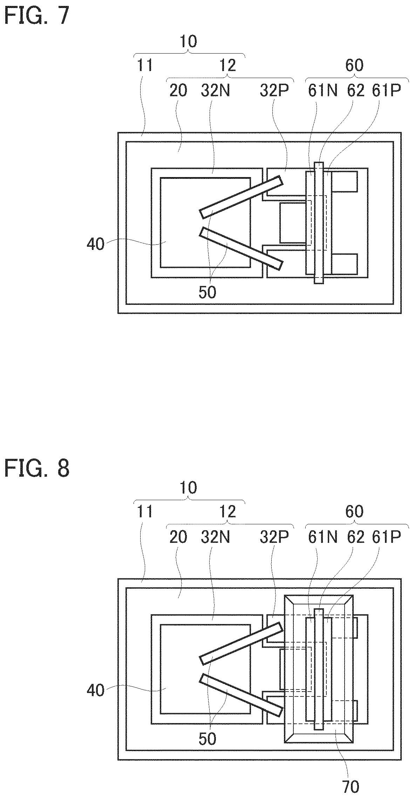

Next, as illustrated in Fig. 7, the terminal assembly 60 is placed to stand at a predetermined position adjacent to the boundary between the first terminal conductor piece 32N and the second terminal conductor piece 32P. At this point, the rear surface of the foot of the first stand-up terminal 61N is bonded to the first terminal conductor piece 32N, and the rear surface of the foot of the second stand-up terminal 61P is bonded to the second terminal conductor piece 32P. This bonding may be made by a bonding method such as soldering, metal particle sintering, conductive paste bonding, ultrasonic impact treatment, and laser welding.

Next, as illustrated in Fig. 8, the ring-shaped plug 70 having the insulating properties is formed at a predetermined position adjacent to the boundary between the inner lead and the outer lead of the respective stand-up terminals 61 by use of a dedicated molding jig (an open-type metallic mold) aligned with respect to the base body 10. The ring-shaped plug 70 is thus precisely formed to the position aligned with respect to the base body 10. The specific forming method for the ring-shaped plug 70 is described in detail below.

Thereafter, the transfer molding is executed. In particular, the precursor structure body 1P of the molded semiconductor device 1 is put in the dedicated metallic mold aligned with respect to the base body 10, the metallic mold is fastened, and fused resin is poured therein. The fused resin is then thermally hardened. Then the precursor structure body IP is released (removed) from the metallic mold and is subjected to trimming so as to complete the molded semiconductor device 1 according to the first embodiment.

The manufacturing method described above can be modified in various ways. The common condition necessary for all of the modifications is to execute the step of forming the ring-shaped plug 70 after the step of attaching the terminal assembly 60 to the circuit substrate 12 and before the step of executing the transfer molding.

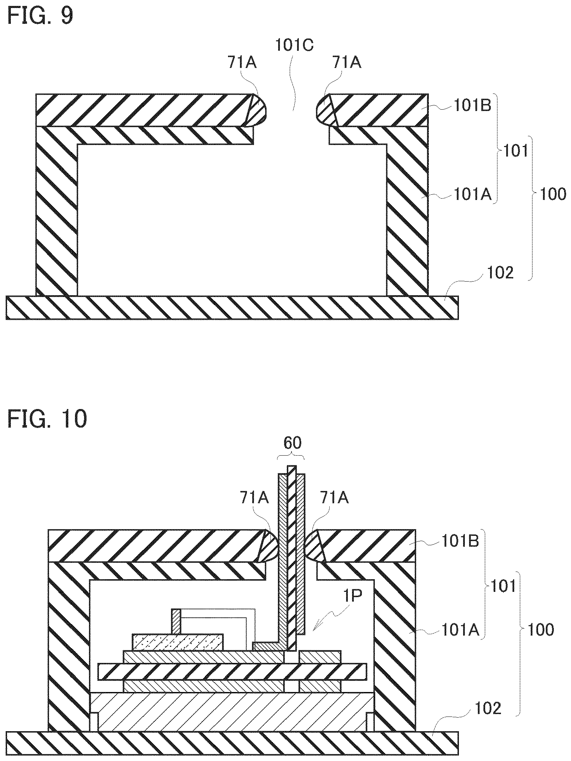

The method of forming the ring-shaped plug 70 is described below. A configuration of a plug-forming jig 100 used for forming the ring-shaped plug 70 is described first with reference to Fig. 9. The plug-forming jig 100 is a resin-forming jig designed to be attached to the precursor structure body 1P before forming the ring-shaped plug 70 so as to be aligned with respect to the base body 10. The plug-forming jig 100 includes a surface plate 102 on which the base body 10 provided with the stand-up terminals 61 is placed, and an upper jig 101 placed on the surface plate 102. The upper jig 101 includes a main jig 101A, and an auxiliary jig 101B removably mounted on the top surface of the main jig 101A. The upper jig 101 is provided, at a position corresponding to the stand-up terminals 61, with a cavity 101C that is a gap through which the stand-up terminals 61 pass when the plug-forming jig 100 is arranged at a regular position aligned with respect to the base body 10. As described below, the ring-shaped plug 70 is formed at the cavity 101C.

The main jig 101A and the auxiliary jig 101B are each divided into two parts in the horizontal direction about the position at which the stand-up terminals 61 are arranged, and each of the divided parts is slidable in the horizontal direction along the main surface of the surface plate 102 so as to vary the gap therebetween. The width of the cavity 101C thus can be varied. The surface of the plug-forming jig 100 is presumed to be subjected to surface treatment (such as Teflon (registered trademark) film coating or application of a releasing agent) so as to impart the releasability with respect to the material of the ring-shaped plug 70.

The method of forming the ring-shaped plug 70 by use of the plug-forming jig 100 is described below. First, as illustrated in Fig. 9, the external edge of the auxiliary jig 101B around the cavity 101C is partly filled with an adhesive 71A in a paste state before hardening. For example, the adhesive 71A is filled by an ejection device such as a syringe. A side wall surface of the cavity 101C having a reversely-tapered shape with the upper part narrower than the lower part corresponds to the external edge of the ring-shaped plug 70 having a truncated cone shape.

After the adhesive 71A is filled, the plug-forming jig 100 is attached to the precursor structure body 1P before the ring-shaped plug 70 is formed, as illustrated in Fig. 10. In particular, after the precursor structure body 1P is placed on the surface plate 102, the main jig 101A and the auxiliary 101B are slid in the horizontal direction to narrow down the cavity 101C to a predetermined width. For example, the width of the cavity 101C is narrowed down so that the adhesive 71A is brought into contact with the side surface of the terminal assembly 60.

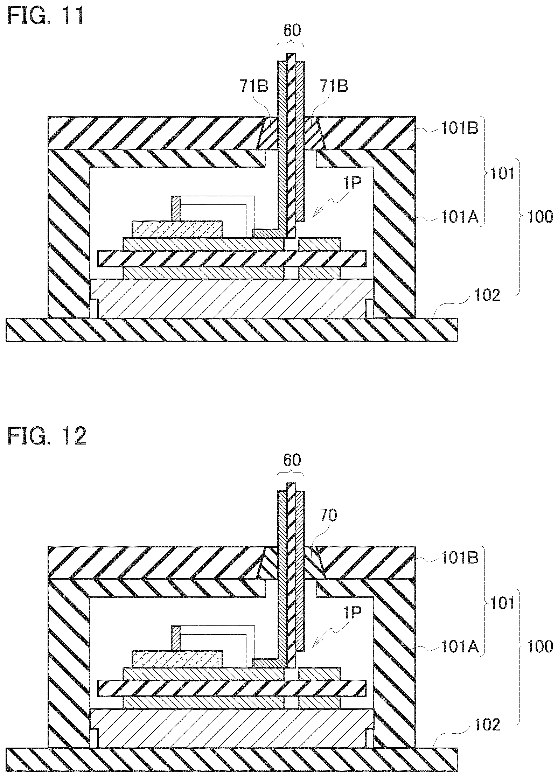

Next, as illustrated I Fig. 11, a gap between the external edge around the cavity 101C and the respective stand-up terminals 61 is filled with another adhesive 71B in a paste state before hardening ejected from the device such as a syringe from the upper part of the plug-forming jig 100. The rest of the gap of the cavity 101C is thus filled with the adhesive. The adhesive 71B overflowed from the top surface of the auxiliary jig 101B is removed by a scraper before the adhesive 71B is hardened.

The adhesive 71B is then left in this state for a predetermined period, so as to be hardened to form the ring-shaped plug 70, as illustrated in Fig. 12. The adhesive 71B may be irradiated with infrared light to be heated so as to promote the hardening.

Thereafter, the plug-forming jig 100 is removed (released) from the precursor structure body 1P. The precursor structure body 1P is thus completed in which the ringshaped plug 70 is fixed and bonded to the side surface of the terminal assembly 60.

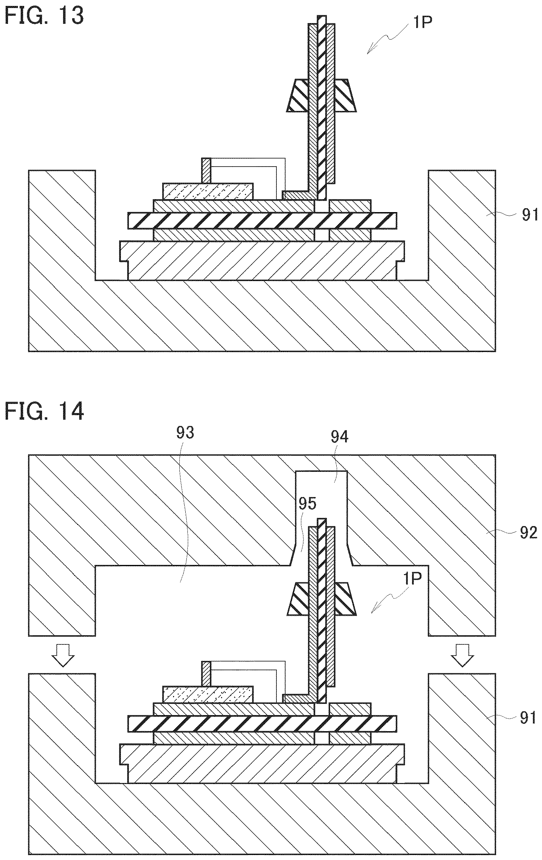

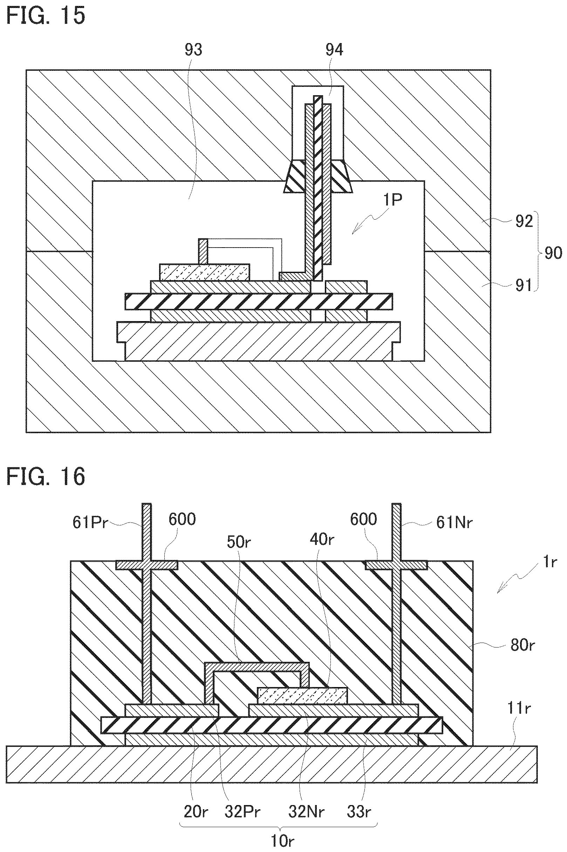

Fig. 13 is a view illustrating a state in which the precursor structure body 1P of the molded semiconductor device 1 is mounted on a lower metallic mold 91 used as a metallic mold for the transfer molding. Fig. 14 is a view illustrating a state immediately before attaching an upper metallic mold 92 to the lower metallic mold 91, in which the lower metallic mold 91 is attached to the upper metallic mold 92 from above, as indicated by the arrows. Fig. 15 is a view illustrating a state in which a metallic mold 90 with the upper metallic mold 92 attached to the lower metallic mold 91 is clamped. A molded region 93 is a region of the cavity of the metallic mold 90 to which the encapsulating resin 80 is injected, and a non-molded region 94 is a region without being filled with the encapsulating resin 80. The metallic mold 90 is precisely aligned with respect to the base body 10 so as to be attached to the precursor structure body 1P.

The ring-shaped plug 70 is formed at the circumference of the side surface of the terminal assembly 60 while being aligned not with respect to the terminal assembly 60 but precisely with respect to the base body 10. Similarly, the metallic mold 90 is also designed to be precisely aligned with respect to the base body 10 so as to be attached to the precursor structure body 1P. This prevents the terminal assembly 60 from strongly coming into contact with a tapered open part 95 of the non-molded region 94 provided at the upper metallic mold 92, and prevents an excessive gap from being provided, so that the lower metallic mold 91 and the upper metallic mold 92 are smoothly fitted together, as illustrated in Fig. 15. The boundary between the molded region 93 of the metallic mold 90 to which the encapsulating resin is injected and the non-molded region 94 without being filled with the encapsulating resin is plugged up with the ring-shaped plug 70.

Since the ring-shaped plug 70 has a truncated cone shape having a narrower width at the upper end than at the lower end, the ring-shaped plug 70 can be fitted to the open part 95 of the non-molded region 94 if the central position of the ring-shaped plug 70 is slightly displaced from the central position of the open part 95 of the non-molded region 94. This can isolate the non-molded region 94 from the molded region 93 by the ring-shaped plug 70.

The method of manufacturing the semiconductor device according to the first embodiment can prevents the stand-up terminals 61 from strongly coming into contact with the metallic mold 90 upon the clamping during the transfer molding if the stand-up terminals 61 are displaced or inclined from the designed position in the vertical and horizontal directions. This prevents the stand-up terminals 61 from being bent or coming off.

A comparative example as illustrated below has some problems with stand-up terminals that come into contact with a metallic mold used for transfer molding and are damaged.

A semiconductor device 1r of the comparative example as illustrated in Fig. 16 includes a base body 10r having a structure including a ceramic plate 20r having a flat shape that is provided on the front surface with a metal plate 32Nr and a metal plate 32Pr each provided with a circuit pattern, and is provided on the rear surface with a thin metal plate 33r. A semiconductor chip 40r is bonded to the top surface of the metal plate 32Nr, and a front-surface electrode of the semiconductor chip 40r and the metal plate 32Pr are connected to each other via an interconnect 50r. The semiconductor chip 40r is covered with a hard encapsulating resin 80r subjected to transfer molding. The encapsulating resin 80r is a composite of thermosetting epoxy resin and filler, for example.

A stand-up terminal 61Nr and a stand-up terminal 61Pr (collectively referred to below as "stand-up terminals 61r") with the respective lower ends bonded to the metal plate 32Nr and the metal plate 32Pr by soldering, are each a metal terminal having a cylindrical straight stick-like shape. A boundary between an inner lead and an outer lead of the respective stand-up terminals 61r is provided with an encapsulating-resin leakage-prevention valve 600 by expansion processing.

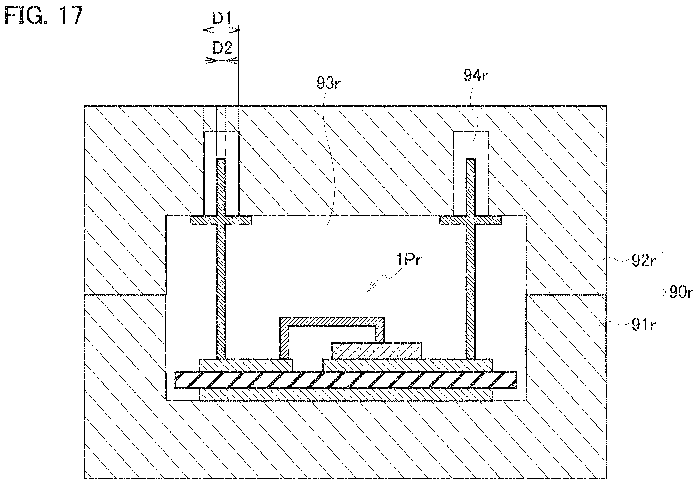

The respective encapsulating-resin leakage-prevention valves 600 function as follows in the step of the transfer molding. Fig. 17 is a view illustrating a state in which a precursor structure body 1Pr of the semiconductor device 1r illustrated in Fig. 16 is put in a metallic mold 90r used for the transfer molding, and the metallic mold 90r is then clamped. The metallic mold 90r includes an upper metallic mold 92r and a lower metallic mold 91r. A molded region 93r is a region in which the encapsulating resin 80r is injected, and a non-molded region 94r is a region without being filled with the encapsulating resin 80r. An outer lead of the respective stand-up terminals 61r is inserted to the non-molded region 94r.

A sufficient clearance G is provided between the inner wall surface of the non-molded region 94r and the outer lead of the respective stand-up terminals 61 as a difference between an inner diameter D1 of the non-molded region 94r and an outer diameter D2 of the outer lead. The clearance G is given by: G = D1 - D2. This prevents damage such as cracks or bending of the respective stand-up terminals 61r derived from the contact of the outer lead of the respective stand-up terminals 61r with the non-molded region 94r when inserted therein. The respective encapsulating-resin leakage-prevention valves 600 each serve as a "valve" for plugging the open part of the non-molded region 94r. Namely, the fused encapsulating resin 80r when injected to the molded region 93r is prevented from entering the non-molded region 94r by the respective encapsulating-resin leakage-prevention valves 600.

The metallic mold 90r is removed after the encapsulating resin is thermally hardened, so as to complete the semiconductor device 1r of the comparative example as illustrated in Fig. 16. Fig. 16 illustrates the case in which a base plate 11r is bonded to the metal plate 33r placed on the rear surface of the base body 10r after the completion of the semiconductor device 1r. The base plate 11r serves as a heat sink.

The following are problems of the semiconductor device 1r and the manufacturing method for the semiconductor device 1r:
(1) The respective stand-up terminals 61 can be damaged in a case in which the encapsulating-resin leakage-prevention valves 600 are formed in the stand-up terminals 61r at a position higher than as designed or inclined with respect to the extending direction of the respective stand-up terminals 61r. In particular, the stand-up terminals 61r can be bent or removed if strongly coming into contact with the non-molded region 94r of the metallic mold 90r when the metallic mold 90r is clamped upon the transfer molding;
(2) The encapsulating-resin leakage-prevention valves 600, which are formed in the stand-up terminals 61r to extend in the horizontal direction by the expansion processing, cannot be formed in the stand-up terminals having a plate-like shape;
(3) The plural stand-up terminals 61r cannot be arranged adjacent to each other because of the contact of the respective encapsulating-resin leakage-prevention valves 600 with each other;
(4) A reduction in stray inductance of the stand-up terminals 61r is hard to achieve because of the structural restrictions as described in items (2) and (3) above; and
(5) The contact between the respective stand-up terminals 61r and the metallic mold 90r can be caused more easily as the number of the stand-up terminals 61r increases, which requires the metallic mold to be designed so as to have an unnecessarily larger clearance G between the respective outer leads and the inner wall surface of the non-molded region 94r.

In addition, the transfer molding has the following problems if the base body 10r, which is thin, has a greater area:
(6) The base body 10r is easily damaged upon the clamping of the metallic mold 90r, which reduces the yield; and
(7) Deformation such as a warp or a swell is easily caused in the base body 10r.
The base plate 11r, if attached to the rear surface of the base body 10r having a warp or a swell, leads to a reduction in heat releasing performance, and causes a variation in heat releasing performance depending on the position. This leads to an unstable operation of the semiconductor chip 40r.

In contrast, in the molded semiconductor device 1 and the manufacturing method for the semiconductor device 1 according to the first embodiment, the alignment is made on the basis of the base body 10 including the base plate 11, so as to form the ring-shaped plug 70 and attach the metallic mold 90 to the precursor structure body 1P. This prevents the respective stand-up terminals 61 from strongly coming into contact with the metallic mold 90.

The respective stand-up terminals 61 of the molded semiconductor device 1 has the structure in which the rear surface of the foot is fixed and bonded to the respective upper-surface conductor pieces 32. This structure leads to a wider bonding area of the respective stand-up terminals 61 with respect to the upper-surface conductor pieces 32 and contributes to higher bonding strength than the case of using the straight stick-shaped stand-up terminals 61r of the semiconductor device 1r of the comparative example as illustrated in Fig. 16. The present embodiment thus can avoid the problem that the stand-up terminals 61 are bent or come off if coming into contact with the metallic mold 90.

The molded semiconductor device 1 has a configuration in which the plate-shaped first stand-up terminal 61N and second stand-up terminal 61P are arranged perpendicular to the circuit substrate 12 via the thin insulating plate 62. This configuration enables the first stand-up terminal 61N and the second stand-up terminal 61P to be arranged adjacent to each other while being electrically isolated from each other. The present embodiment thus can deal with the problems (2) and (3) described above.

In the molded semiconductor device 1, a main current flows in a dispersed state through the plate-shaped first stand-up terminal 61N and second stand-up terminal 61P. This can reduce self-inductance. In addition, the main current flows in the opposite directions through the first stand-up terminal 61N and the second stand-up terminal 61P arranged adjacent to each other. Namely, a sum of the current flowing into the terminal assembly 60 and the current flowing out of the terminal assembly 60 is zero. This leads mutual inductance between the first stand-up terminal 61N and the second stand-up terminal 61P to a large negative value. This can reduce stray inductance in the stand-up terminals 61 of the molded semiconductor device 1 greatly to a smaller value than parasitic inductance in the stand-up terminals 61r of the semiconductor device 1r of the comparative example. The present embodiment thus can deal with the problem (4) as described above.

In the molded semiconductor device 1, the plural stand-up terminals 61 are precisely combined via the insulating plate 62 to fabricate the terminal assembly 60. Bundling and combining the stand-up terminals 61 together can achieve the effect of decreasing the number of the stand-up terminals 61 positioned independently of each other. The present embodiment thus can greatly relax the restriction on the design of the metallic mold to lead to an unnecessarily large clearance G, with regard to the problem (5) as described above.

The molded semiconductor device 1 has a configuration in which the base body 10 includes the solid base plate 11. The molded semiconductor device 1 has the advantage of reducing the possibility that the base body 10 would be damaged or deformed during the transfer molding. The present embodiment thus can deal with the problems (6) and (7) as described above.

In the semiconductor device 1r of the comparative example, the base plate 11r is bonded to the rear surface of the base body 10r with an adhesive after the resin encapsulation. If the base body 10r has a warp or a swell caused by the heating step during the resin encapsulating, a gap between the rear surface of the base body 10r and the base plate 11r is led to be uneven, providing both a region in which the adhesive is thick and a region in which the adhesive is thin. The region in which the adhesive is thick causes a decrease in heat conductivity and an increase in heat resistance, as compared with the region in which the adhesive is thin. The variation in the heat resistance tends to be increased particularly when the area of the base body 10r is large.

In contrast, in the semiconductor device according to the first embodiment, the precursor structure body 1P including the base body 10 in which the base plate 11 and the circuit substrate 12 are stacked together is sealed with the resin. This can evenly reduce the gap between the base plate 11 and the circuit substrate 12. The semiconductor device according to the first embodiment can increase the number of the stand-up terminals and increase the area of the base body 10 while avoiding an increase in heat resistance.

### <First Modified Example>

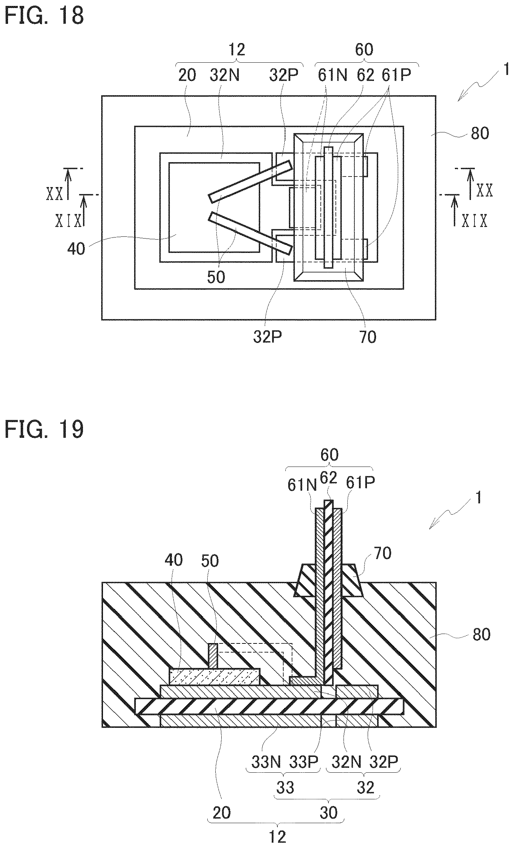

When the molded semiconductor device 1 has a smaller size in a plan view, for example, when the main surface has the dimensions within two centimeters in length and width, the circuit substrate 12 is relatively solid. The insulating substrate 20 thus has a less risk of being damaged or deformed upon the clamping during the transfer molding. The circuit substrate 12 in this case may be used to serve as the base body 10 to fabricate the molded semiconductor device 1, as illustrated below with a semiconductor device according to a first modified example shown in Fig. 18 to Fig. 20.

The molded semiconductor device 1 according to the first modified example differs from the molded semiconductor device 1 described in the above embodiment in that the base body 10 does not include the base plate 11. The other configurations are the same as those of the molded semiconductor device 1 as illustrated in Fig. 1 to Fig. 3, and the structure and the manufacturing method are not described below so as not repeat overlapping explanations thereof.

The ring-shaped plug 70 in the molded semiconductor device 1 according to the first modified example is also precisely aligned with respect to the circuit substrate 12 serving as a base body. The first modified example thus can deal with the problems (1) to (5) as described above. The structure according to the first modified example can also be used in a second embodiment and a third embodiment described below.

### <Second Modified Example>

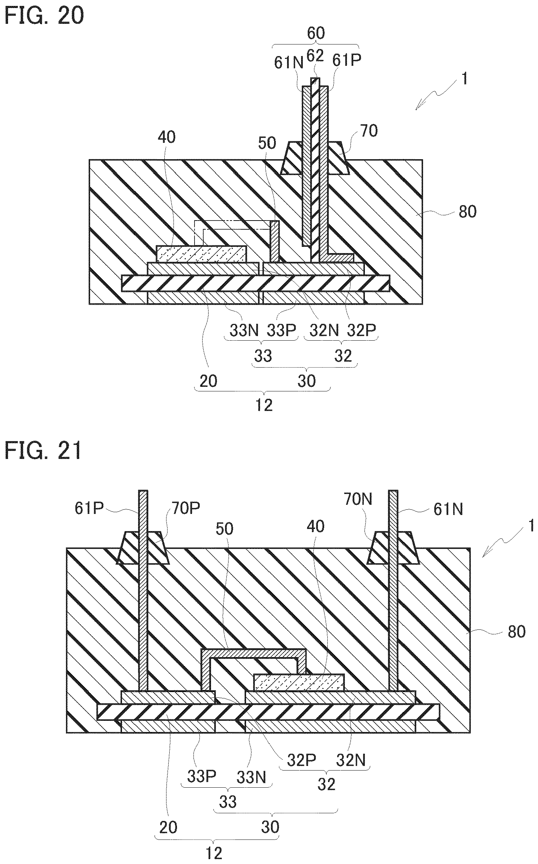

A molded semiconductor device 1 according to a second modified example of the first embodiment as illustrated in Fig. 21 has a configuration similar to that of the semiconductor device 1r of the comparative example as illustrated in Fig. 16 but excluding the encapsulating-resin leakage prevention valves 600. In particular, the rear-surface electrode of the semiconductor chip 40 is bonded to the first terminal conductor piece 32N of the circuit substrate 12 serving as a base body, and the front-surface electrode of the semiconductor chip 40 is connected to the second terminal conductor piece 32P via the interconnect 50. The lower end of the first stand-up terminal 61N is connected to the first terminal conductor piece 32N, and the lower end of the second stand-up terminal 61P is connected to the second terminal conductor piece 32P. The first stand-up terminal 61N and the second stand-up terminal 61P each may have either a straight stick-like shape or a plate-like shape.

A first ring-shaped plug 70N is fixed and bonded adjacent to the boundary between the inner lead and the outer lead of the first stand-up terminal 61N, and a second ring-shaped plug 70P is fixed and bonded adjacent to the boundary between the inner lead and the outer lead of the second stand-up terminal 61P. The first ring-shaped plug 70N and the second ring-shaped plug 70P are precisely aligned to be formed with respect to the circuit substrate 12 serving as a base body.

This configuration prevents the respective stand-up terminals 61 from strongly coming into contact with the open part or the inner wall surface of the non-molded region due to the resin encapsulating by use of the metallic mold designed to be precisely aligned with respect to the circuit substrate 12. The second modified example thus can avoid damage to the respective stand-up terminals 61 regardless of the exclusion of the terminal assembly 60 of the respective stand-up terminals 61, when the respective stand-up terminals 61 have a straight stick-like shape, instead of a plate-like shape.

### <Third Modified Example>

The method of forming the ring-shaped plug 70 of the molded semiconductor device 1 is illustrated above with the case of using the adhesive (the material) in a paste state before hardening. The demand for the use of various adhesives having different types of characteristics regarding heat resistance and pressure resistance is presumed to increase. The ring-shaped plug 70 may be formed by use of an adhesive (material) having low viscosity, as illustrated below with a forming method as a modified example.

The method of forming the ring-shaped plug 70 according to the third modified example also uses the plug-forming jig 100 as illustrated in Fig. 9. Any additional jig does not need to be manufactured for executing the forming method according to the third modified example.

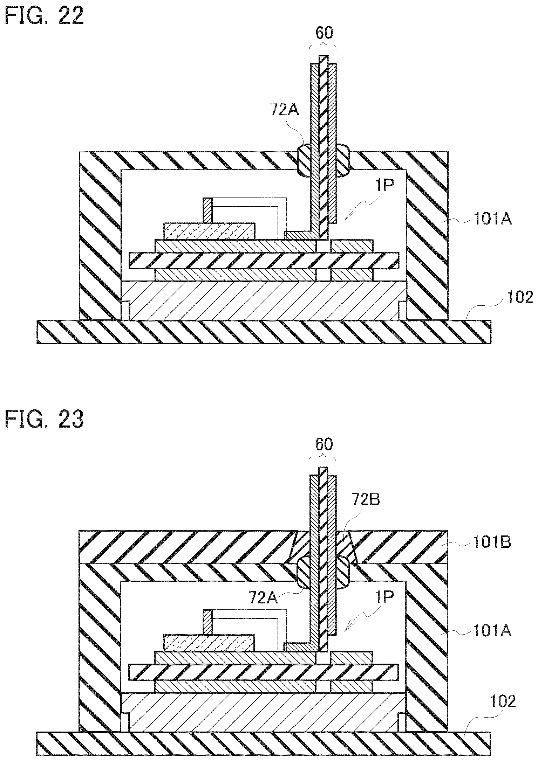

The method of forming the ring-shaped plug 70 as a modified example is described below with reference to Fig. 22 to Fig. 25. This forming method can also be applied to the method of forming the ring-shaped plug 70 according to the second embodiment or the third embodiment as described below.

As illustrated in Fig. 22, first, the main jig 101A of the plug-forming jig 100 is attached to the precursor structure body 1P of the molded semiconductor device 1 mounted on the surface plate 102. The auxiliary jig 101B at this point is not placed on the top surface of the main jig 101A yet. A sealant 72A having high viscosity is applied to seal the gap between the terminal assembly 60 and the main jig 101A. The sealant 72A to be used may be, but not necessarily, a silicone sealant, for example.

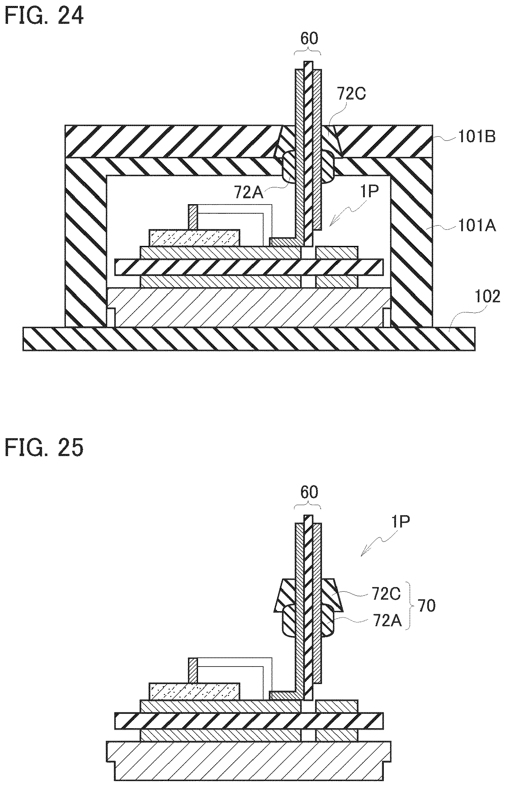

After the sealant 72A is hardened, the auxiliary jig 101B is placed on the main jig 101A. As illustrated in Fig. 23, an adhesive 72B having low viscosity is injected between the gap between the terminal assembly 60 and the auxiliary jig 101B. The term "low viscosity" as used herein refers to a level not in a paste state before the hardening but sufficient to avoid dropping through the gap between the plug-forming jig 100 and the terminal assembly 60. The injection of the adhesive 72B is made with a syringe, for example. The adhesive 72B overflowed from the top surface of the auxiliary jig 101B is removed by nonwoven fabric or a scraper before the adhesive 72B is hardened completely. The adhesive 72B is then hardened so as to form an adhesive 72C as illustrated in Fig. 24.

Thereafter, the plug-forming jig 100 is removed from the precursor structure body 1P, so as to complete the precursor structure body 1P in which the ring-shaped plug 70 composed of the hardened adhesive 72C and sealant 72A is formed on the side surface of the terminal assembly 60, as illustrated in Fig. 25.

As described above, the method of forming the ring-shaped plug 70 according to the third modified example applies the adhesive having high viscosity to the gap between the terminal assembly 60 and the main jig 101A, and then applies the adhesive having lower viscosity thereto. This method can use the adhesive with the low viscosity for the ring-shaped plug 70. Namely, the method can increase the options upon choosing the adhesives.

### (Second Embodiment)

The semiconductor device according to the first embodiment described above has the configuration in which the semiconductor chip 40 includes the semiconductor element having two terminals such as a diode element. A semiconductor device according to a second embodiment has a configuration in which the semiconductor chip 40 includes a semiconductor element having three terminals such as a transistor element. The term "semiconductor element having three terminals" includes a MOSFET, an IGBT, a BJT, a JFET, and a HEMT including a gate electrode or a base electrode serving as a control electrode to which a control signal for controlling an ON/OFF operation is input. As described below, the semiconductor device according to the second embodiment further includes a constituent element for inputting control signals additionally in the semiconductor device according to the first embodiment.

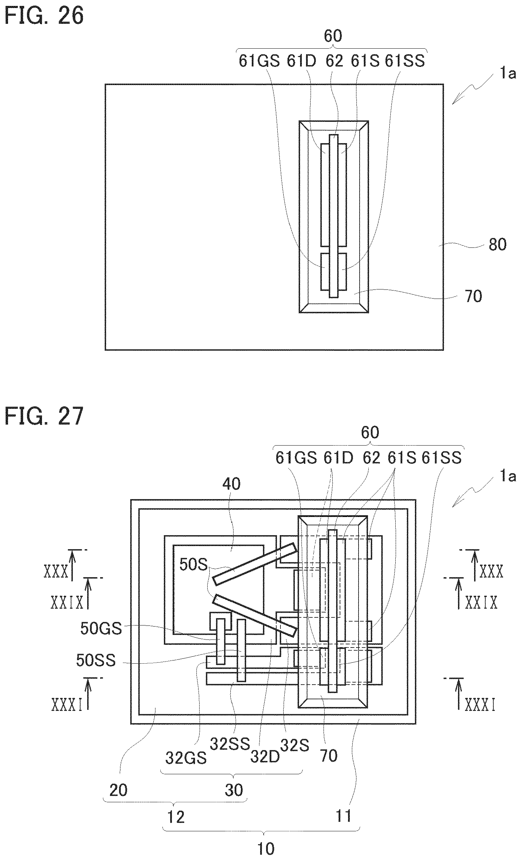

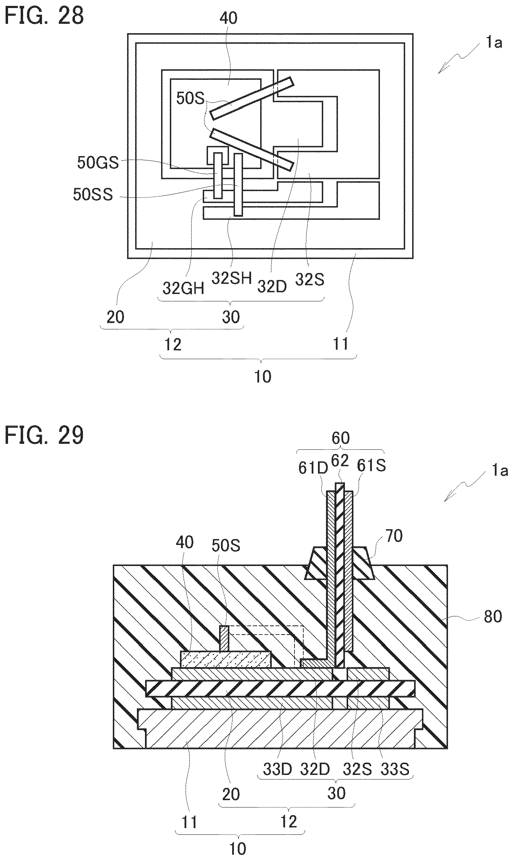

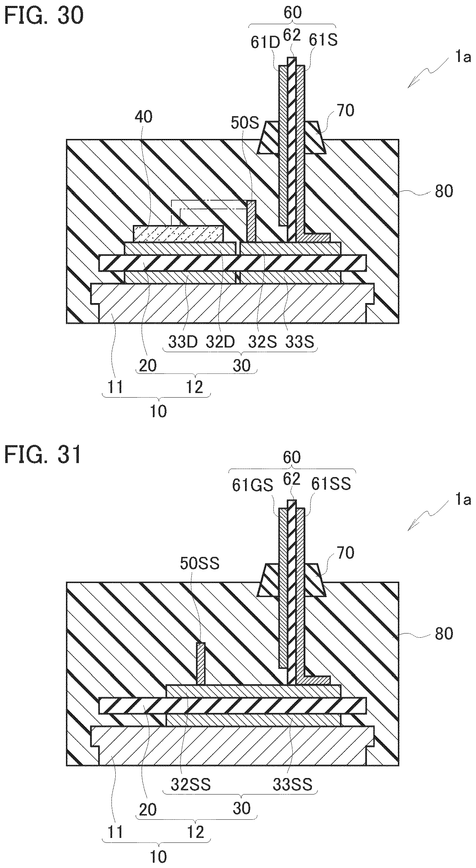

The configuration of the molded semiconductor device 1a according to the second embodiment is described below with reference to Fig. 26 to Fig. 31. Fig. 26 is a plan view, Fig. 27 is a plan view omitting the illustration of the encapsulating resin 80, and Fig. 28 is a plan view omitting the illustration of the encapsulating resin 80, the terminal assembly 60, and the ring-shaped plug 70. Fig. 29 is a cross-sectional view taken along XXIX-XXIX direction in Fig. 27, Fig. 30 is a cross-sectional view taken along XXX-XXX direction in Fig. 27, and Fig. 31 is a cross-sectional view taken along XXXI-XXXI direction in Fig. 27. The present embodiment is illustrated below with a case in which the semiconductor element having three terminals is a power MOSFET.

The molded semiconductor device 1a according to the second embodiment includes the base body 10 including the base plate 11 and the circuit substrate 12 stacked together. The top surface of the insulating substrate 20 composing the circuit substrate 12 is provided with at least four conductor pieces 30 including a drain conductor piece 32D, a source conductor piece 32S, a control-signal conductor piece 32GS, and a source-signal conductor piece 32SS. A main current of the power MOSFET flows between the drain conductor piece 32D and the source conductor piece 32S. The control signal for controlling the ON/OFF operation of the power MOSFET is transmitted to the semiconductor chip 40 via the control-signal conductor piece 32GS.

A source signal is also transmitted via the source-signal conductor piece 32SS. The source signal is a signal indicating a potential of a source electrode, for example. The reason for this is that the potential of the source electrode sometimes varies when a large current flows between the source electrode and a drain electrode. The potential of the source electrode, which is used as a basis for setting a potential of a gate electrode, needs to be detected with a high accuracy.

The semiconductor chip 40 is deposited on the top surface of the drain conductor piece 32D while being bonded to the drain electrode as a rear-surface electrode of the semiconductor chip 40. The source electrode as a front-surface electrode of the semiconductor chip 40 is electrically connected to the source conductor piece 32S via interconnects 50S. The gate electrode provided on the front surface of the semiconductor chip 40 separately from the source electrode is electrically connected to the control-signal conductor piece 32GS via an interconnect 50GS. The source electrode of the semiconductor chip 40 is also electrically connected to the source-signal conductor piece 32SS via an interconnect 50SS.

The drain conductor piece 32D, the source conductor piece 32S, the control-signal conductor piece 32GS, and the source-signal conductor piece 32SS are electrically connected to the respective lower ends of a drain stand-up terminal 61D, a source stand-up terminal 61S, a control-signal stand-up terminal 61GS, and a source-signal stand-up terminal 61SS. The vertical parts of the respective stand-up terminals 61 are arranged on the main surfaces of the insulating plate 62 composing the terminal assembly 60. The respective vertical parts of the drain stand-up terminal 61D, the source stand-up terminal 61S, the control-signal stand-up terminal 61GS, and the source-signal stand-up terminal 61SS are thus positioned adjacent to each other. The boundary between the inner lead and the outer lead of the terminal assembly 60 is provided with the ring-shaped plug 70 precisely aligned with respect to the base body 10. To reduce the stray inductance of the stand-up terminals 61 through which the main current flows, the drain stand-up terminal 61D and the source stand-up terminal 61S are preferably opposed to each other with the insulating plate 62 interposed therebetween. The control-signal stand-up terminal 61GS to which the control signal is transmitted and the source-signal stand-up terminal 61SS to which the source signal is transmitted are opposed to each other with the insulating plate 62 interposed therebetween.

The rear surface of the insulating substrate 20 of the circuit substrate 12 may be provided with the lower-surface conductor pieces opposed to the upper-surface conductor pieces 32. This avoids a warp of the circuit substrate 12 caused by the heating step. For example, the lower-surface conductor pieces 33D, 33S, 33GS (not illustrated), and 33SS are arranged to be opposed to the drain conductor piece 32D, the source conductor piece 32S, the control-signal conductor piece 32GS, and the source-signal conductor piece 32SS via the insulating substrate 20.

The molded semiconductor device 1a includes the four stand-up terminals 61 assembled together, which look like a single stand-up terminal implementing the terminal assembly 60. This configuration further improves the effects derived from the assembly of the stand-up terminals 61. The terminal assembly 60 through which the main current flows may be additionally provided separately from the terminal assembly 60 to which the signals are transmitted. In particular, the molded semiconductor device 1a may include the terminal assembly 60 including the drain stand-up terminal 61D and the source stand-up terminal 61S assembled together, and the terminal assembly 60 including the control-signal stand-up terminal 61GS and the source-signal stand-up terminal 61SS assembled together. The respective terminal assemblies 60 in this case are each independently provided with the ring-shaped plug 70.

The molded semiconductor device 1a has the same configuration of the circuit through which the main current of the semiconductor element provided on the semiconductor chip 40 flows as the molded semiconductor device 1 according to the first embodiment. The molded semiconductor device 1a according to the second embodiment thus can similarly achieve all of the effects as described in the first embodiment.

In addition to the effects described above, the molded semiconductor device 1a according to the second embodiment can further achieve the original effects. The molded semiconductor device 1a has the configuration in which the control-signal stand-up terminal 61GS and the source-signal stand-up terminal 61SS are arranged to be opposed with the thin insulating plate 62 interposed therebetween. The direction of a gate signal current flowing into the semiconductor chip 40 from the control-signal stand-up terminal 61GS is opposite to the direction of a source signal current flowing out toward the source-signal stand-up terminal 61SS from the semiconductor chip 40. This configuration can reduce stray inductance caused in the control-signal stand-up terminal 61GS and the source-signal stand-up terminal 61SS. The reduction in the stray inductance of the signal terminals further contributes to an improvement in switching speed and a reduction in switching loss in the transistor element.

When the source signal does not need to be used, the source-signal conductor piece 32SS and the source-signal stand-up terminal 61SS are not necessarily included.

### (Third Embodiment)

The respective embodiments of the present invention can also be applied easily to a case of a semiconductor device including two or more semiconductor chips.

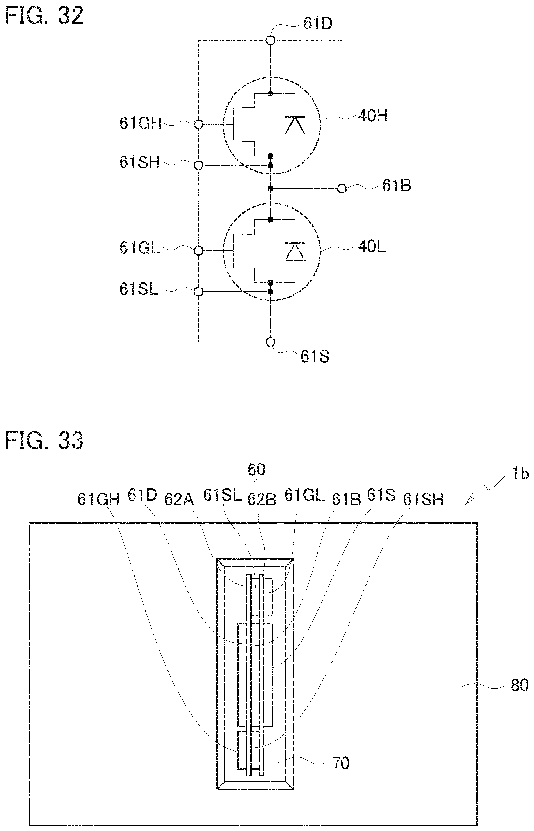

For example, a case is described below in which the embodiments of the present invention are applied to a half-bridge power module as illustrated in the circuit diagram in Fig. 32. The half-bridge circuit illustrated in Fig. 32 includes a semiconductor chip 40H and a semiconductor chip 40L each provided with a transistor element (such as a power MOSFET) having a body diode and arranged to form a bridge connection (connected together in series). The half-bridge power module has a configuration in which a connection point between the semiconductor chip 40H serving as an upper arm and the semiconductor chip 40L serving as a lower arm is defined as an independent output terminal of the half-bridge circuit. The semiconductor device according to the third embodiment is configured such that the half-bridge power module illustrated in Fig. 32 is encapsulated with resin by the transfer molding while including the stand-up terminals 61. The circuit diagram in Fig. 32 illustrates the respective terminals denoted by the reference numerals of the stand-up terminals 61 as described below.

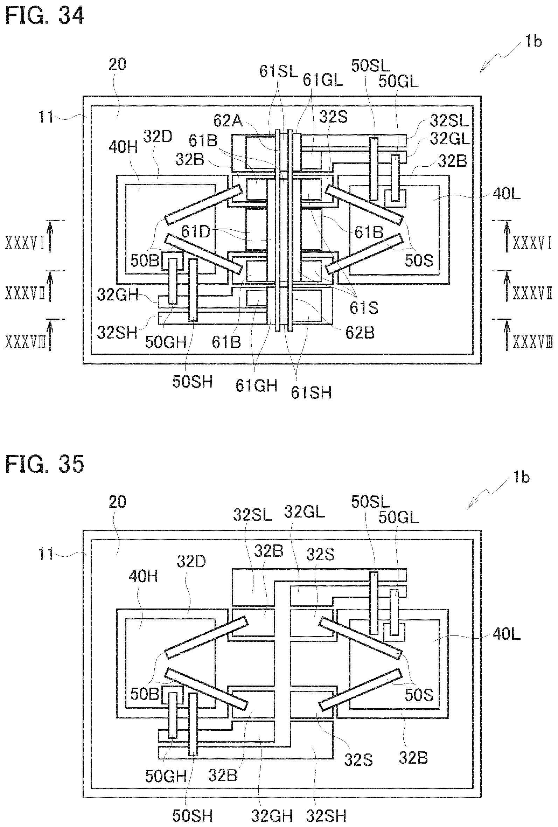

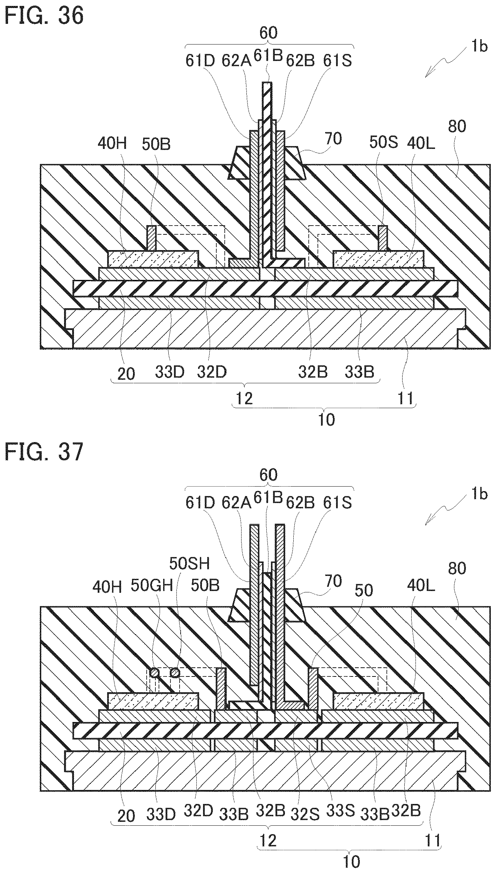

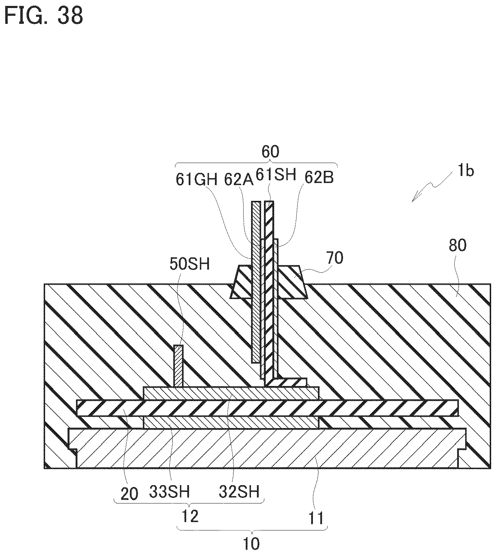

The configuration of the molded semiconductor device 1b according the third embodiment is described below with reference to Fig. 33 to Fig. 38. Fig. 33 is a plan view, Fig. 34 is a plan view omitting the illustration of the encapsulating resin 80, and Fig. 35 is a plan view omitting the illustration of the encapsulating resin 80, the terminal assembly 60, and the ring-shaped plug 70. Fig. 36 is a cross-sectional view taken along XXXVI-XXXVI direction in Fig. 34, Fig. 37 is a cross-sectional view taken along XXXVII-XXXVII direction in Fig. 34, and Fig. 38 is a cross-sectional view taken along XXXVIII-XXXVIII direction in Fig. 34. The present embodiment is illustrated below with a case in which the semiconductor chip 40H and the semiconductor chip 40L are each a power MOSFET.

The molded semiconductor device 1b according the third embodiment includes the base body 10 including the base plate 11 and the circuit substrate 12 stacked together. The top surface of the insulating substrate 20 composing the circuit substrate 12 is provided with at least seven upper-surface conductor pieces 32 including a drain conductor piece 32D, a source conductor piece 32S, an upper-side control-signal conductor piece 32GH, an upper-side source-signal conductor piece 32SH, a bridge conductor piece 32B, a lower-side control-signal conductor piece 32GL, and a lower-side source-signal conductor piece 32SL.

A rear-surface drain electrode of the semiconductor chip 40H is bonded on the top surface of the drain conductor piece 32D. The front-surface source electrode of the semiconductor chip 40H is electrically connected to the bridge conductor piece 32B via interconnects 50B. The gate electrode provided on the front surface of the semiconductor chip 40H separately from the source electrode is electrically connected to the upper-side control-signal conductor piece 32GH via an interconnect 50GH. The source electrode of the semiconductor chip 40H is electrically connected to the upper-side source-signal conductor piece 32SH via an interconnect 50SH.

A rear-surface drain electrode of the semiconductor chip 40L is bonded on the top surface of the drain conductor piece 32B. The front-surface source electrode of the semiconductor chip 40L is electrically connected to the bridge conductor piece 32S via interconnects 50S. The gate electrode provided on the front surface of the semiconductor chip 40L separately from the source electrode is electrically connected to the lower-side control-signal conductor piece 32GL via an interconnect 50GL. The source electrode of the semiconductor chip 40L is electrically connected to the lower-side source-signal conductor piece 32SL via an interconnect 50SL.

The drain conductor piece 32D, the upper-side control-signal conductor piece 32GH, the upper-side source-signal conductor piece 32SH, and the bridge conductor piece 32B are electrically connected to the respective lower ends of a drain stand-up terminal 61D, an upper-side control-signal stand-up terminal 61GH, an upper-side source-signal stand-up terminal 61SH, and a bridge stand-up terminal 61B. The source conductor piece 32S, the lower-side control-signal conductor piece 32GL, and the lower-side source-signal conductor piece 32SL are electrically connected to the respective lower ends of a source stand-up terminal 61S, a lower-side control-signal stand-up terminal 61GL, and a lower-side source-signal stand-up terminal 61SL.

The vertical parts of the respective stand-up terminals 61 are arranged along the respective main surfaces of the insulating plates 62A and 62B composing the terminal assembly 60 arranged perpendicular to the main surface of the circuit substrate 12. In particular, the vertical parts of the drain stand-up terminal 61D and the upper-side control-signal stand-up terminal 61GH are arranged on one of the main surfaces of the insulating plate 62A. The vertical parts of the upper-side source-signal stand-up terminal 61SH, the bridge stand-up terminal 61B, and the lower-side source-signal stand-up terminal 61 SL are arranged to be interposed between the other main surface of the insulating plate 62A and one of the main surfaces of the insulating plate 62B. The vertical parts of the source stand-up terminal 61S and the lower-side control-signal stand-up terminal 61GL are arranged on the other main surface of the insulating plate 62B.

The respective vertical parts of the drain stand-up terminal 61D, the upper-side control-signal stand-up terminal 61GH, the upper-side source-signal stand-up terminal 61SH, the bridge stand-up terminal 61B, the source stand-up terminal 61S, the lower-side control-signal stand-up terminal 61GL, and the lower-side source-signal stand-up terminal 61SL are thus positioned adjacent to each other due to the terminal assembly 60. In particular, the drain stand-up terminal 61D and the bridge stand-up terminal 61B are opposed to each other with the insulating plate 62A interposed therebetween, and the bridge stand-up terminal 61B and the source stand-up terminal 61S are opposed to each other with the insulating plate 62B interposed therebetween. The upper-side control-signal stand-up terminal 61GH and the upper-side source-signal stand-up terminal 61SH are opposed to each other with the insulating plate 62A interposed therebetween. The lower-side control-signal stand-up terminal 61GL and the lower-side source-signal stand-up terminal 61SL are opposed to each other with the insulating plate 62B interposed therebetween. The boundary between the inner lead and the outer lead of the terminal assembly 60 is provided with the ring-shaped plug 70 precisely aligned with respect to the base body 10.

As described above, the bridge stand-up terminal 61B as an output terminal of the half-bridge power module is led out to the outside of the encapsulating resin 80 as the terminal assembly 60 provided with the ring-shaped plug 70 at the circumference of the side surface of the terminal assembly 60.

The rear surface of the insulating substrate 20 of the circuit substrate 12 is preferably provided with the lower-surface conductor pieces 33 opposed to the upper-surface conductor pieces 32. The lower-surface conductor piece 33D, the lower-surface conductor piece 33GH (not illustrated), the lower-surface conductor piece 33SH, and the lower-surface conductor piece 33B are arranged to be opposed to the drain conductor piece 32D, the upper-side control-signal conductor piece 32GH, the upper-side source-signal conductor piece 32SH, and the bridge conductor piece 32B, respectively. The lower-surface conductor piece 33S, the lower-surface conductor piece 33GL (not illustrated), and the lower-surface conductor piece 33SL (not illustrated) are arranged to be opposed to the source conductor piece 32S, the lower-side control-signal conductor piece 32GL, and the lower-side source-signal conductor piece 32SL.

The semiconductor device according to the third embodiment includes the seven stand-up terminals 61 assembled together, which look like a single stand-up terminal implementing the terminal assembly 60. This configuration further improves the effects derived from the assembly of the stand-up terminals 61. The terminal assembly 60 through which the main current flows may be additionally provided separately from the terminal assembly 60 to which the signals are transmitted. In addition, the upper-side control-signal stand-up terminal 61GH and the upper-side source-signal stand-up terminal 61SH that transmit the signals to the semiconductor chip 40H may be assembled together to implement the single terminal assembly 60, and the lower-side control-signal stand-up terminal 61GL and the lower-side source-signal stand-up terminal 61SL that transmit the signals to the semiconductor chip 40L may be assembled together to implement the other single terminal assembly 60. The number of the stand-up terminals 61 assembled together to implement the single terminal assembly 60 can be determined as appropriate. When the plural terminal assemblies 60 are used, the ring-shaped plug 70 is fixed and bonded individually to each of the terminal assemblies 60.

### (Other Embodiments)

While the respective embodiments according to the present invention have been described above, it should be understood that the present invention is not intended to be limited to the descriptions and the drawings composing part of this disclosure. Various alternative embodiments, examples, and technical applications will be apparent to those skilled in the art according to this disclosure.

While the embodiments have been illustrated above with the case in which the semiconductor element provided on the semiconductor chip 40 includes the front-surface electrode and the rear-surface electrode, all of the electrodes of the semiconductor element may be provided on the front surface of the semiconductor chip 40. For example, the stand-up terminals 61 may be connected to the respective top-surface conductor pieces 32 electrically and separately connected to the respective electrodes of a planar transistor via interconnects.

While the embodiments have been illustrated above with the case in which the vertical parts of the stand-up terminals 61 are arranged on both surfaces of the insulating plate 62 of the terminal assembly 60, the vertical parts of the stand-up terminals 61 may be arranged only one of the main surfaces of the insulating plate 62.

### INDUSTRIAL APPLICABILITY

The semiconductor device and the method of manufacturing the semiconductor device according to the present invention can be used in electronics industries including manufacturing industries for manufacturing semiconductor devices encapsulated with resin by transfer molding.

### REFERENCE SIGNS LIST

- 1: MOLDED SEMICONDUCTOR DEVICE
- 10: BASE BODY
- 11: BASEPLATE
- 12: CIRCUIT SUBSTRATE
- 20: INSULATING SUBSTRATE
- 30: CONDUCTOR PIECE
- 32: UPPER-SURFACE CONDUCTOR PIECE
- 33: LOWER-SURFACE CONDUCTOR PIECE
- 40: SEMICONDUCTOR CHIP
- 50: INTERCONNECT
- 60: TERMINAL ASSEMBLY
- 61: STAND-UP TERMINAL
- 62: INSULATING PLATE
- 70: RING-SHAPED PLUG
- 80: ENCAPSULATING RESIN

## Claims

1. A semiconductor device comprising:
a base body;
a semiconductor chip deposited on a top surface of the base body;
an encapsulating resin covering the semiconductor chip;
a ring-shaped plug having an insulating property, buried in a part of an upper part of the encapsulating resin, and having a top surface exposed to an outside of the encapsulating resin; and
a stand-up terminal including a vertical part penetrating the ring-shaped plug and extending in a direction perpendicular to the top surface of the base body, and having a lower end electrically connected to an electrode of the semiconductor chip inside the encapsulating resin and an upper end exposed to the outside of the encapsulating resin,
wherein the ring-shaped plug is fixed and bonded to a circumference of a side surface of the vertical part of the stand-up terminal.

2. The semiconductor device according to claim 1, wherein the ring-shaped plug is an adhesive hardened at the circumference of the side surface of the stand-up terminal.

3. The semiconductor device according to claim 1, wherein;
the stand-up terminal has a plate-like shape;
the vertical part of the stand-up terminal is arranged on a main surface of an insulating plate and combined together to implement a terminal assembly; and
the ring-shaped plug is fixed and bonded to a circumference of the terminal assembly.

4. The semiconductor device according to claim 3, wherein:
the semiconductor chip includes a semiconductor element through which a main current flows between a front-surface electrode provided on a front surface of the semiconductor chip and a rear-surface electrode provided on a rear surface of the semiconductor chip;
the base body includes a circuit substrate in which a first terminal conductor piece and a second terminal conductor piece are deposited on a main surface of an insulating substrate;
the first terminal conductor piece and the rear-surface electrode are electrically connected to each other;
the second terminal conductor piece and the front-surface electrode are electrically connected to each other; and
the vertical part of the first stand-up terminal having the lower end connected to the first terminal conductor piece and the vertical part of the second stand-up terminal having the lower end connected to the second terminal conductor piece are arranged on the insulating plate and opposed to each other while interposing the insulating plate therebetween.

5. The semiconductor device according to claim 3, wherein:
the semiconductor chip includes a semiconductor element including a front-surface electrode provided on a front surface of the semiconductor chip, a rear-surface electrode provided on a rear surface of the semiconductor chip, and a control electrode configured to control an on/off state of a main current flowing between the front-surface electrode and the rear-surface electrode;
the base body includes a circuit substrate in which a first terminal conductor piece, a second terminal conductor piece, and a control-signal conductor piece are deposited on a main surface of an insulating substrate;
the first terminal conductor piece and the rear-surface electrode are electrically connected to each other;
the second terminal conductor piece and the front-surface electrode are electrically connected to each other;
the control-signal conductor piece and the control electrode are electrically connected to each other; and
the vertical part of the first stand-up terminal having the lower end connected to the first terminal conductor piece and the vertical part of the second stand-up terminal having the lower end connected to the second terminal conductor piece are arranged on the insulating plate and opposed to each other while interposing the insulating plate therebetween.

6. The semiconductor device according to claim 5, wherein the vertical part of the stand-up terminal having the lower end connected to the control-signal conductor piece to receive a control signal transmitted thereto is arranged on the same insulating plate as the first stand-up terminal and the second stand-up terminal.

7. The semiconductor device according to claim 5, wherein:
the semiconductor device comprises at least two of the semiconductor chips each including the semiconductor element;
the semiconductor element provided on one of the semiconductor chips and the semiconductor element provided on the other semiconductor chip are connected in series to implement a half-bridge circuit; and
an output terminal of the half-bridge circuit is led out to the outside of the encapsulating resin as the stand-up terminal connected to the output terminal.

8. The semiconductor device according to claim 1, wherein at least a part of the stand-up terminal has an L-shape including a longitudinal part that is the vertical part and a short part that is connected to the electrode of the semiconductor chip.

9. The semiconductor device according to claim 1, wherein:
the base body has a configuration in which a circuit substrate provided with a circuit pattern and electrically connected to the electrode of the semiconductor chip is deposited on a top surface of a base plate having greater hardness than the circuit substrate; and
at least side and top surfaces of the base plate are covered with the encapsulating resin.

10. A method of manufacturing a semiconductor device, the method comprising:
depositing a semiconductor chip on a top surface of a base body;
depositing a stand-up terminal having a vertical part extending in a direction perpendicular to the top surface of the base body on the top surface of the base body such that a lower end of the stand-up terminal is electrically connected to an electrode of the semiconductor chip;
forming a ring-shaped plug having an insulating property at a circumference of a side surface of the vertical part of the stand-up terminal at a position aligned with respect to the base body; and
encapsulating the semiconductor chip with resin by transfer molding by use of a metallic mold aligned with respect to the base body,
wherein a boundary between a molded region of the metallic mold to which an encapsulating resin is injected and a non-molded region without being filled with the encapsulating resin is plugged by the ring-shaped plug during the transfer molding.

11. The method of manufacturing the semiconductor device according to claim 10, wherein the ring-shaped plug is formed by use of an adhesive hardened at the circumference of the side surface of the stand-up terminal.

12. The method of manufacturing the semiconductor device according to claim 11, wherein the forming the ring-shaped plug includes:
preparing a plug-forming jig designed to be aligned and attached with respect to the base body, the plug-forming jig including a surface plate, and an upper jig placed on the surface plate and having a gap at a region at which the stand-up terminal is to be positioned when the base body is placed on the surface plate, the upper jig being configured to vary a width of the gap;
filling an external edge of a circumference of the gap of the upper jig with the adhesive;
placing the base body on which the stand-up terminal is arranged on the surface plate; and
filling a rest of a space of the gap with another adhesive after narrowing down the gap to a predetermined width.

13. The method of manufacturing the semiconductor device according to claim 12, wherein:
the upper jig includes a main jig and an auxiliary jig removably placed on a top surface of the main jig;
the base body is placed on the surface plate before placing the auxiliary jig on the top surface of the main jig;
a sealant is applied to seal the gap between the stand-up terminal and the main jig; and
the auxiliary jig is placed on the top surface of the main jig after hardening the sealant, and an adhesive having lower viscosity than the sealant is applied to seal the gap between the stand-up terminal and the main jig.

14. The method of manufacturing the semiconductor device according to claim 10, wherein:
the vertical part of the stand-up terminal having a plate-like shape is arranged on at least one of main surfaces of an insulating plate to form a terminal assembly including the insulating plate and the stand-up terminal combined together; and
the ring-shaped plug is formed at a circumference of the terminal assembly.
